# EUROPÄISCHE PATENTANMELDUNG

(11) **EP 2 246 669 A2**
(43) Veröffentlichungstag der Anmeldung: **03.11.2010**
(21) Anmeldenummer: 10003275.4
(22) Anmeldetag: 26.03.2010
(51) Int. Cl.: G01D 5/241, G01D 11/24

(54) **Kapazitiver Drehsensor**

(30) Priorität: 28.04.2009 DE 102009019172
(71) Anmelder: Hengstler GmbH, 78554 Aldingen (DE)
(72) Erfinder: Held, Siegfried, 78166 Donaueschingen (DE); Bücher, Johann, 78554 Aldingen (DE); Wöhrstein, Andreas, 78126 Königsfeld (DE)
(74) Vertreter: Riebling, Peter

(57) **Zusammenfassung**

Kapazitiver Drehsensor zum Erfassen der Position eines sich relativ zu einem stationären Objekt bewegenden Objekts, bestehend aus einer drehbar in einem Gehäuseflansch gelagerten Welle, die drehfest mit einem Rotor verbunden ist, dem durch einen Luftspalt getrennt gegenüberliegend ein Stator zugeordnet ist, wobei mindestens Rotor, der Stator und eine Auswerteschaltung von einer elektrisch leitfähigen Kappe umgeben sind, wobei an der Unterseite einer Leiterplatte eine Statorfläche angeordnet ist und dass der Statorfläche gegenüberliegend und durch den Luftspalt getrennt eine nichtrotationssymmetrische Rotorscheibe zugeordnet ist, die ihrerseits auf einem Rotorträger befestigt ist, welcher Rotorträger drehfest am Außenumfang der Welle hochgenau befestigt ist.

## Beschreibung

Gegenstand der Erfindung ist ein kapazitiver Drehsensor nach dem Oberbegriff des Patentanspruches 1. Ein solcher kapazitiver Drehsensor ist beispielsweise mit dem Gegenstand der EP 1 173 730 B1 (DE 600 16 395 T2) bekannt geworden. Bei diesem Drehsensor besteht allerdings der Nachteil, dass er relativ aufwendig und teuer herzustellen ist, denn dort wird vorausgesetzt, dass eine außen liegende Rotorwelle lediglich im Presssitz auf einen innen liegenden, vertikalen Flansch einer Rotorscheibe aufgepresst wird, um so den Drehsensor mechanisch zusammenzubauen.

Mit diesem Aufbau besteht jedoch der Nachteil, dass bei der Anordnung eines Presssitzes zwischen einem vertikalen Flansch der Rotorscheibe und dem Außenumfang der Rotorwelle eine bestimmte Unwucht oder ein Schlag (Taumel-Fehler) an der Rotorscheibe vorhanden ist, der mit einer elektrischen Auswerteschaltung nur schwierig zu korrigieren ist.

Ferner besteht bei der bekannten Anordnung der Nachteil, dass eine die gesamte Anordnung umgreifende Haube fehlt, insbesondere eine solche Haube, die ein Drehlager für die Rotorwelle aufweist, um die Rotorwelle möglichst genau und zentrisch sowie schlagfrei zu führen.

Nachdem bei diesem bekannten Drehsensor eine Eigenlagerung der Rotorwelle fehlt, werden eventuelle Rundlauffehler oder Schlagfehler, die von einem antreibenden Motor auf die Rotorwelle übertragen werden, unmittelbar über die zirkulare Presspassung auf die Rotorscheibe übertragen und bilden so einen weiteren Beitrag zum Taumel-Fehler.

Demzufolge ist das System nach dem Stand der Technik relativ aufwendig aufgebaut und in der Auswertung eines Drehwinkels ungenau.

Der Erfindung liegt die Aufgabe zugrunde, einen Drehsensor der eingangs genannten Art so weiterzubilden, dass bei wesentlich geringeren Herstellkosten eine größere Genauigkeit im Hinblick auf die elektrische Auflösung des Messergebnisses erreicht wird.

Ferner liegt der Erfindung die untergeordnete Aufgabe zugrunde, einen möglichst kostengünstigen Drehsensor zu verwirklichen, der eine hohe Genauigkeit aufweist.

Zur Lösung der gestellten Aufgabe ist die Erfindung durch die technische Lehre des Anspruches 1 gekennzeichnet.

Wesentliches Merkmal der Erfindung ist, dass die elektronische Auswerteschaltung auf einer Leiterplatte angeordnet ist, an deren Unterseite unmittelbar direkt elektrisch leitfähig eine Statorfläche angeordnet ist und dass der Statorfläche gegenüberliegend und durch einen Luftspalt getrennt eine nicht-rotationssymmetrische Rotorscheibe zugeordnet ist, die ihrerseits in einem Rotorträger befestigt ist, welcher Rotorträger formschlüssig am Außenumfang der Rotorwelle hochgenau befestigt ist.

Mit der gegebenen technischen Lehre ergibt sich der wesentliche Vorteil, dass bei einem einfachen Aufbau eine hohe Genauigkeit des Messergebnisses erzielt wird.

Der einfache Aufbau wird dadurch erreicht, dass die Leiterplatte, welche die elektronische Auswerteschaltung und unter Anderem auch die Schaltung zur Fehlerkorrektur trägt, an ihrer Unterseite gleichzeitig die elektrisch leitfähige Statorfläche trägt, welche bevorzugt aus einer Kupferleiterbahn ausgebildet ist, die mit einem Isolierlack beschichtet ist.

Damit kommt der Leiterplatte eine Doppelfunktion zu, nämlich einerseits als Träger für die Erfassungs-, Auswerte- und Fehlerkorrekturschaltung und gleichzeitig als Träger für die Statorfläche, die als elektrisch leitfähige Kupferfläche an der Unterseite der Leiterplatte angeordnet ist und mit einem Isolierlack beschichtet ist.

Zur Erreichung einer hochgenauen, gegen Unwucht geschützten Anordnung ist es ferner vorgesehen, dass die durch den Luftspalt getrennte und gegenüberliegend angeordnete Rotorscheibe lediglich ebenfalls nur aus einer Kupferfläche besteht, die auf einem Rotorträger angeordnet ist, welcher Rotorträger bevorzugt aus einem elektrisch isolierenden Kunststoffmaterial gebildet ist.

Der Rotorträger ist also ein einfaches, kostengünstiges Kunststoffteil, welches hochgenau und formschlüssig am Außenumfang der Welle aufgepasst ist, während auf dem Rotorträger eine einseitig offene Ausnehmung angeordnet ist, in welche die Rotorscheibe eingesetzt ist, die über die Drehrichtung gesehen exzentrisch ausgebildet ist.

Damit ergibt sich ein besonders einfacher und kostengünstiger Aufbau, der im Übrigen auch hochgenau ist.

Durch die Befestigung der Rotorscheibe, die aus einem dünnen Kupfermaterial besteht, in einer einseitig offenen Ausnehmung des Rotorträgers, ergibt sich eine besonders einfache Fertigung.

Die Befestigung einer solchen einfachen Kupferscheibe in einer Ausnehmung des Rotorträgers, der aus Kunststoff ausgebildet ist, kann z. B. durch Kleben, mittels eines Klebers oder durch Einlegung eines Kleberings erfolgen, der doppelt klebend ausgebildet ist und der mit seiner unteren Fläche in der Ausnehmung des Rotorträgers eingeklebt ist und mit seiner oberen klebenden Fläche einen Klebeverbund mit der Unterseite der Rotorscheibe eingeht.

Selbstverständlich ist die Erfindung nicht darauf beschränkt, dass die exzentrisch ausgebildete Rotorscheibe aus einem kostengünstigen Kupfermaterial besteht. In einer anderen Ausgestaltung kann es vorgesehen sein, dass die Rotorscheibe aus Aluminium oder Stahl besteht, welche wiederum in der vorher beschriebenen Weise in einer Aussparung des Rotorträgers eingesetzt und dort bevorzugt über einen Kleber oder eine Klebescheibe befestigt ist.

Mit der gegebenen technischen Lehre ergibt sich der Vorteil, dass durch die hochgenaue Aufspannung des Rotorträgers auf dem Außenumfang der Welle ein Verzug oder ein Schlagen der Rotorscheibe verhindert wird, denn es wird eine Presspassung im Sinne des Standes der Technik (siehe obige Beschreibung) vermieden. Stattdessen gibt es nach der Erfindung verschiedene Ausführungsformen, wie eine bestimmte spannungsfreie Aufspannung des Rotorträgers auf dem Außenumfang der Welle vorgenommen werden kann:
1. In einer ersten Ausführungsform ist es vorgesehen, dass am Außenumfang der Welle eine Verzahnung angeordnet ist und der Rotorträger an seinem Innenumfang ebenfalls eine zugeordnete Verzahnung aufweist, so dass eine drehfeste, formschlüssige Verbindung zwischen Rotorträger und dem Außenumfang der Welle vorhanden ist, ohne dass eine Presspassung vorhanden wäre, die zu einer Unwucht führt.
2. In einer zweiten Ausführung ist es vorgesehen, dass der Rotorträger aus einem geeigneten Kunststoffmaterial besteht und unmittelbar an den Außenumfang der metallischen Welle angespritzt ist, um so einen spannungsfreien Formschluss mit dem Außenumfang der Welle zu erreichen.

Ein weiteres wesentliches Merkmal zur Erreichung einer hochgenauen Lagerung der Leiterplatte, die gleichzeitig den Stator trägt, ist, dass erfindungsgemäß vorgesehen ist, dass die Leiterplatte durch einen Flansch in der den gesamten Drehsensor abdeckenden Kappe angeordnet ist und die Kappe sich ihrerseits an einem Gehäuseflansch abstützt, welcher Gehäuseflansch über eine Drehlageranordnung auf der Welle zentriert ist.

Auf diese Weise wird eine hochgenaue Maßübertragung dadurch erreicht, dass zunächst am Außenumfang der Welle bevorzugt zwei gegeneinander vorgespannte Kugellager vorgesehen sind, welche den Gehäuseflansch tragen. Damit ist sichergestellt, dass der Gehäuseflansch gut zentriert auf dem Außenumfang der Welle 3 möglichst reibungsarm und schlagfrei gelagert ist. Erfindungsgemäß ist nun vorgesehen, dass der Außenumfang des Gehäuseflansches als Zentrierfläche für den Innenumfang der darauf gesteckten Kappe dient und dass diese Kappe dieses zentrische Maß auf einen axial innen liegenden Ring-Flansch (röhrenförmiger Zentrieransatz) überträgt, an dessen unteren Stirnseite eine Abschrägung vorhanden ist, an der hochgenau mit Hilfe einer Passfläche die innere Stirnseite der Leiterplatte anliegt, um so hochgenau im Gehäuse zentriert zu werden.

Auf diese Weise wird hochgenau das Maß vom Außenumfang der Welle über die vorher genannten Kugellager über den Gehäuseflansch übertragen und vom Außenumfang des Gehäuseflansches über die hochgenau gearbeitete Kappe auf den Innenumfang des zentrischen Ringflansches (Zentrieransatz) der Kappe übergeleitet, an deren Innenumfang wiederum die radial innen liegende Stirnseite der Leiterplatte zentriert ist.

In einer abgewandelten Auführung ist es vorgesehen, dass statt der Innenzentrierung der Leiterplatte eine Außenzentrierung gegeben ist. In diesem Fall legt sich der Außenumfang der Leiterplatte zentrisch und hochgenau am Innenumfang des Gehäuseflansches oder der Kappe an.

Damit wird gesorgt, dass der an der Unterseite der Leiterplatte angeordnete Stator hochgenau im Gehäuse zentriert ist.

In einer Weiterbildung der vorliegenden Erfindung ist es vorgesehen, dass dieses in sich zentrierte und gelagerte System mit einem hochgenauen Luftspalt ausgestattet ist, der zwischen dem Rotor und dem Stator ausgebildet ist.

Dieser Luftspalt wird nämlich einfach durch Überdrehen (spanabhebende rotierende Bearbeitung) der Rotorscheibe erreicht. Ebenso kann auch ein Fräsen oder Schleifen angewendet werden.

Ein eventuell bei der Montage entstehender Höhenschlag wird dadurch vermieden, indem bei eingebautem Rotor nochmals der Rotor überdreht wird, um so einen gleichmäßig sich über den gesamten Radius erstreckenden Luftspalt zu erreichen, der deshalb über seine radiale Erstreckung genau gleich bleibend parallel zu dem gegenüberliegenden Stator ausgebildet ist.

Besonders vorteilhaft ist es, wenn die in den Rotorträger eingelegte exzentrische Rotorscheibe etwas über die Dicke des Rotorträger hinaus steht, um dann diese überstehende Fläche genau zentrisch abdrehen zu können, um so einen sich über die radiale Strecke von innen nach außen parallel erstreckenden Luftspalt zu erhalten.

Sollte wider Erwarten noch ein Restfehler vorhanden sein, so wird dieser erfindungsgemäß durch eine auf der Leiterplatte angeordnete Elektronikschaltung mit entsprechender Fehlerkorrektur kompensiert.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen, einschließlich der Zusammenfassung offenbarten Angaben und Merkmale, insbesondere die in den Zeichnungen dargestellte räumliche Ausbildung, werden als erfindungswesentlich beansprucht, soweit sie einzeln oder in Kombination gegenüber dem Stand der Technik neu sind.

Im Folgenden wird die Erfindung anhand von lediglich einen Ausführungsweg darstellenden Zeichnungen näher erläutert. Hierbei gehen aus den Zeichnungen und ihrer Beschreibung weitere erfindungswesentliche Merkmale und Vorteile der Erfindung hervor.

Es zeigen:
- Figur 1:: schematisiert einen Mittenlängsschnitt durch einen kapazitiven Drehsensor
- Figur 2:: Draufsicht auf den Drehsensor nach Figur 1 bei abgenommener Kappe

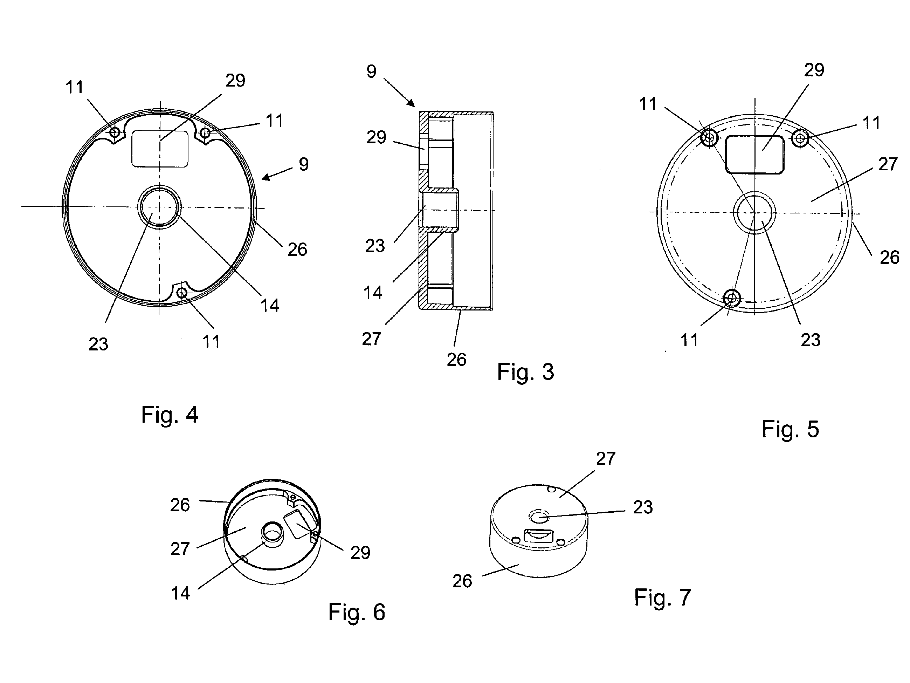

- Figur 3:: Schnitt durch die Kappe
- Figur 4:: Innenansicht der Kappe
- Figur 5:: Außenansicht der Kappe
- Figur 6:: perspektivisch die Innenansicht der Kappe
- Figur 7:: perspektivisch die Außenansicht der Kappe
- Figur 8:: perspektivische Ansicht des Rotorträgers
- Figur 9:: eine vergrößerte Schnittdarstellung durch den Rotorträger im Bereich der Mittenbohrung
- Figur 10:: Schnitt durch den Rotorträger nach Figur 8
- Figur 11:: Draufsicht auf den Rotorträger nach Figur 10
- Figur 12:: perspektivisch die Überdeckung der Statorfläche durch die exzentrische Rotorfläche
- Figur 13:: die gleiche Darstellung wie Figur 12 mit weiteren Einzelheiten
- Figur 14:: das elektrische Ersatzschaltbild, welches sich nach der Anordnung nach Figur 12 und 13 ergibt
- Figur 15:: die zwischen Rotor und Stator abgeleitete Kapazität bei Volldrehung des Rotors um 360 Grad
- Figur 16-18:: die aus der Figur 15 abgeleiteten weiteren Kurven der Kapazität, und zwar zeigen die Figuren 16 und 17 die aus den einzelnen Quadranten der Rotorscheibe abgeleiteten Kapazitätswerte, die zu einem Gesamtkapazitätswert gemäß Figur 18 zusammengefasst werden
- Figur 19:: die Draufsicht auf den Stator mit 4 gleichmäßigen Quadranten
- Figur 20:: die Draufsicht auf den Klebering, der die Rotorscheibe im Rotorträger festlegt
- Figur 21:: schematisiert eine Schaltung für den Betrieb des kapazitiven Sensors

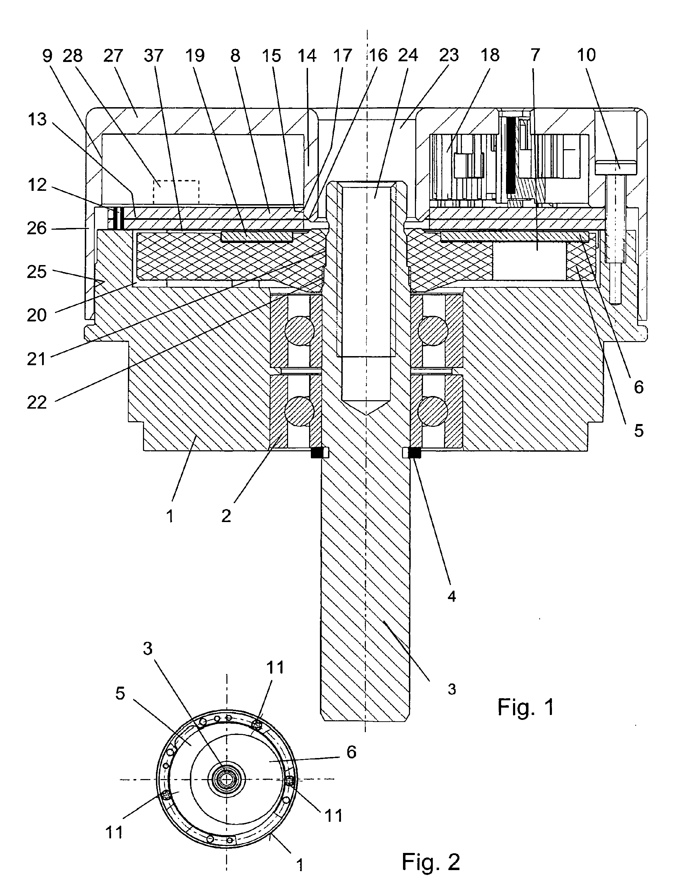

In Figur 1 und 2 ist dargestellt, dass der kapazitive Drehsensor nach der Erfindung im Wesentlichen aus einem, z. B. aus Aluminiumguss bestehenden, Gehäuseflansch 1 besteht, der zylinderförmig ausgebildet ist und in dessen Innenbohrung eine Anordnung von gegeneinander verspannten Kugellagern 2 angeordnet sind.

Die Kugellager 2 sind bevorzugt als Rillenkugellager ausgebildet. In einer anderen Ausgestaltung kann es vorgesehen sein, dass diese Kugellager als Gleitlager oder allgemein als Wälzlager ausgebildet sind.

Im Innenraum wird eine Welle 3 von den Kugellagern 2 aufgenommen, die sich mit einem unteren, verlängerten Teil aus dem Gehäuse des kapazitiven Drehsensors heraus erstreckt und mit Hilfe eines Spannrings 4 gegen Herausfallen gesichert ist. Dieser Spannring 4 kann auch entfallen. Er dient jedoch als zusätzliche Aufnahme für axiale Kräfte, die von der Welle 3 auf den Gehäuseflansch 1 übertragen werden.

In einer noch später genauer zu beschreibenden Art ist ein bevorzugt aus Kunststoff bestehender Rotorträger 5 hochgenau auf dem Außenumfang mit Hilfe einer Rändelpassfläche 21 auf dem Außenumfang der Welle 3 formschlüssig und drehfest angeordnet. Wichtig hierbei ist, dass die Rändelpassfläche 21 eine drehfeste, spannungsfreie Befestigung des Rotorträgers 5 auf dem Außenumfang der Welle 3 ermöglicht. Statt der Rändelpassfläche 5 kann auch ein Vierkant-, ein Zweikant- oder eine Vieleck-Verbindung vorgesehen sein.

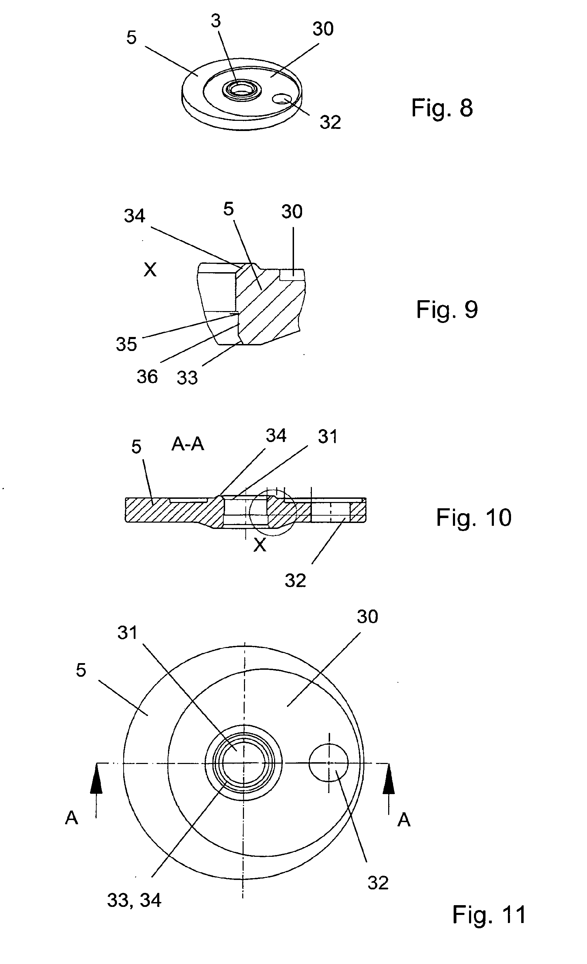

Wichtig ist ferner, dass der Rotorträger 5 an seiner Oberseite eine Vertiefung 30 (siehe Figuren 8 bis 11) trägt, in welcher ein doppelt klebender Klebering 7 eingesetzt ist, der mit seiner einen Klebefläche auf dem Boden der Vertiefung 30 klebt und mit seiner gegenüberliegenden Klebefläche die als schmale Metallfläche ausgebildete Rotorscheibe 6 befestigt.

Auf diese Weise ist eine einfache, hochgenaue Befestigung der Rotorscheibe 6 gegeben, insbesondere dann - wie im allgemeinen Teil beschrieben - wenn die Rotorscheibe 6 nach der Montage auf dem Rotorträger und nach der Montage des Rotorträgers auf der Welle noch nachträglich überdreht wird.

Ferner ist wichtig, dass einem Luftspalt 19 der Rotorscheibe 6 gegenüberliegend eine Statorfläche 37 gegenüberliegt, die als dünne Leiterbahnfläche ausgebildet ist, und zwar in einer Dicke (z.B. 30 bis 100 Mikrometer), wie sie bei üblichen gedruckten Schaltungen vorhanden ist. Es ergibt sich damit eine sehr einfache Herstellung der Statorfläche 37, weil diese in der Art einer metallisierten Kupferleitfläche an der Oberfläche einer gedruckten Leiterplatte 8 angeordnet ist.

Diese Leiterplatte 8 bildet demzufolge an der Unterseite den Stator und trägt an der Oberseite eine Elektronikschaltung 28, in der die Auswerteschaltung und die Fehlerkorrekturschaltung angeordnet sind.

Ferner trägt die Leiterplatte 8 den elektrischen Anschluss 18, der z. B. als Stecker ausgebildet ist und der durch eine in der Kappe angeordnete Aussparung 29 von außen her erreichbar ist.

Die Kappe 9 ist hochgenau z. B. aus einem Aluminiumdruckguss ausgebildet und ist elektrisch leitfähig ausgebildet.

Sie besteht aus einem äußeren vertikalen Flansch 26, der sich als Ringflansch gleichmäßig am Außenumfang des Gehäuseflansches 1 im Bereich einer Passfläche 25 anlegt, wobei dieses Passmaß über den vertikalen Flansch 26 auf den horizontalen Flansch 27 der Kappe 9 übertragen wird und von dort auf einen weiteren Ringflansch 14 der Kappe, welcher der inneren Zentrierung der Leiterplatte 8 dient.

Die Kappe 9 ist über Befestigungsschrauben 10 mit dem Gehäuseflansch 1 verbunden, wobei im Gehäuseflansch 1 entsprechende Befestigungsbohrungen 11 vorhanden sind.

Eine besonders einfache Abschirmung ergibt sich dann, wenn man im Bereich der Leiterplatte 8 noch zusätzlich eine Leitschicht 13 anordnet, die elektrisch leitfähig über Durchkontaktierungen 12 mit dem Gehäuseflansch 1 verbunden sind.

Erfindungsgemäß ist nun eine hochgenaue Zentrierung zwischen dem Ringflansch 14 der Kappe 9 und dem Innenumfang der Leiterplatte 8 vorgesehen. Zu diesem Zweck weist die Leiterplatte 8 am radialen Innenumfang eine Innenbohrung 15 auf, die sich an einer zugeordneten vertikalen Passfläche 17 am Innenumfang des Ringflansches 14 der Kappe 9 anlegt. Es erfolgt hierbei eine Zentrierung über die Abschrägung 16, so dass bei der Montage eine genaue zentrische Ausrichtung über die Abschrägung 16 erfolgt, so dass damit sicher ein Passsitz im Bereich der Passfläche 17 zwischen dem Ringflansch 14 der Kappe 9 und der Innenbohrung 15 der Leiterplatte 8 erreicht werden kann.

Der Rotorträger 5 ist in einer Ausnehmung 20 des Gehäuseflansches 1 drehbar gelagert und ist mit Hilfe der vorher beschriebenen Rändelpassfläche 21 auf dem Außenumfang der Welle 3 zentriert.

Hierzu wird gemäß den Figuren 9 bis 11 im Bereich der Mittenbohrung 31 des Rotorträgers 5 eine obere Klebefläche 34 vorgesehen, die als abgeschrägte Fläche ausgebildet ist, so dass im Bereich dieser Klebefläche 34 eine Kleberaupe angeordnet wird, um so den Rotorträger 5 vor dem Abfallen von der Welle 3 nach oben in axialer Richtung zu schützen.

In Figur 9 ist ferner dargestellt, dass sich an die Passfläche 36, die der Rändelpassfläche 21 gegenüberliegt, eine Anschlagfläche 35 anschließt, so dass eine axiale Begrenzung beim Aufstecken des Rotorträgers 5 auf den Außenumfang der Welle 3 in axialer Richtung gegeben ist.

Der Außenumfang der Welle 3 trägt eine Verzahnung 22, um so eine drehfeste, formschlüssige Verbindung mit dem Rotorträger 5 zu ermöglichen.

Die Kappe 9 trägt an ihrer oberen Seite im Bereich des nach innen gerichteten Ringflansches 14 eine Montageöffnung 23. Damit kann das gesamte Gerät auf eine Antriebswelle aufgepresst und wieder abgezogen werden. Zu diesem Zweck greift ein Gewindedorn durch die Montageöffnung 23, der in die Gewindebohrung 24 der Hohlbohrung in der Stirnseite der Welle 3 eingreift und dort befestigt ist.

Die Figuren 8, 10 und 11 zeigen noch, dass im Rotorträger 5 eine Durchgangsbohrung, eine Sacklochbohrung oder eine Aussparung gemäß Figur 10 ausgebildet ist. Auf diese Weise soll eine Unwucht des Rotorträgers 5 beim Drehen verhindert werden, weil auf dem Rotorträger 5 die exzentrische Rotorscheibe 6 angeordnet ist und dementsprechend eine Unwucht ausüben würde, wenn nicht eine solche Aussparung 32 vorhanden wäre, die als Gewichtsausgleich dient.

Um den Rotorträger 5 günstig auf die Verzahnung 22 der Welle 3 aufstecken zu können, trägt die Mittenbohrung des Rotorträgers 5 gemäß Figur 9 eine Einführschräge 33, die radial nach außen gerichtet ist.

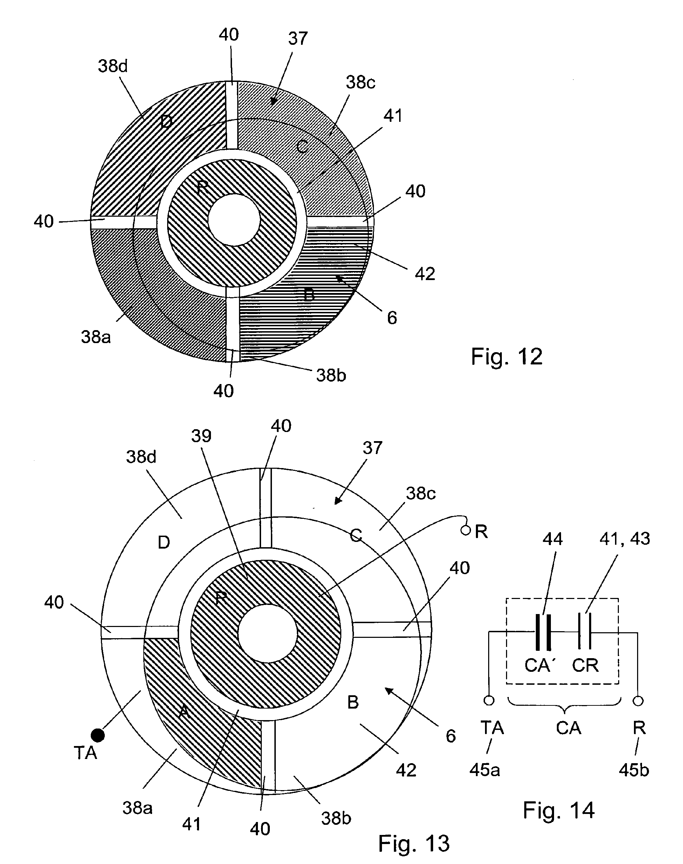

Die Figuren 12 und 13 zeigen die Zuordnung von Rotorscheibe 6 und der zentrischen Statorfläche 37.

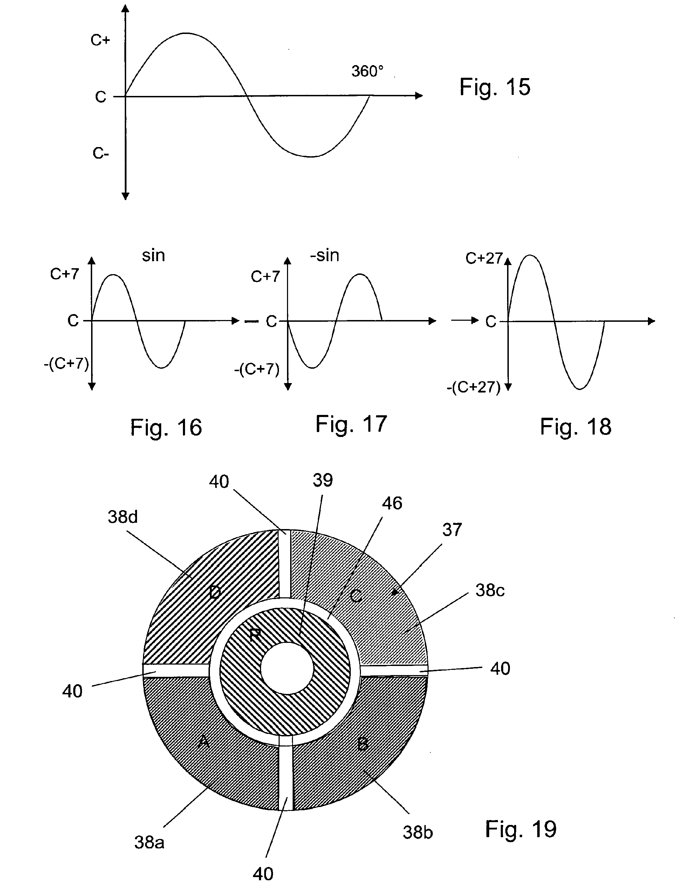

Die Statorfläche 37 weist gemäß Figur 19 elektrisch leitfähige, jedoch durch radial verlaufende Isolierstege voneinander getrennte Quadranten 38a, 38b, 38c, 38d auf, so dass insgesamt vier leitfähige Beläge gegenseitig isoliert sind.

Am Innenumfang sind diese Quadranten 38a-d durch einen umlaufenden, elektrisch isolierenden Isolierring 46 voneinander getrennt.

Im Innenumfang des Isolierrings 46 ist ein elektrisch leitfähiger zentrischer Statorring 39 angeordnet, der mit dem Buchstaben R in Figur 19 bezeichnet ist. Die einzelnen Quadranten 38 sind mit den Großbuchstaben A, B, C, D bezeichnet.

Die Figuren 12 und 13 zeigen die Überdeckung des in Figur 19 dargestellten Stators mit einer exzentrischen Rotorscheibe 6, die ihrerseits aus einem elektrisch leitfähigen, durchgehenden Belag besteht. Die exzentrische Rotorscheibe 6 hat einen inneren Rotorring 41, der als zentrischer Ring ausgebildet ist und der als leitfähiger Belag elektrisch leitfähig mit den übrigen exzentrischen Bereichen der Rotorscheibe 6 verbunden ist. Es handelt sich also um einen virtuellen Rotorring 41, der als gedachte Leitfläche im Bereich der gesamten Leitfläche der exzentrischen Rotorscheibe angeordnet ist. Wichtig ist nämlich, dass dieser gedachte zentrische Rotorring 41 genau dem zentrischen Statorring 39 gegenüberliegt und gemäß Figur 14 eine gleich bleibende, nicht veränderbare Kapazität CR bildet.

Dies ist im Ersatzschaltbild nach Figur 14 dargestellt.

Die exzentrischen Bereiche der Rotorscheibe 6, die den zentrischen Quadranten 38 der Statorfläche 37 gegenüberliegen, ergeben dann im Ersatzschaltbild nach Figur 14 einen variablen Kondensator CA', so dass sich aus diesen beiden Kondensatoren CA' und CR eine Gesamtkapazität CA ergibt. Das Ersatzschaltbild nach Figur 14 ergibt sich für jeden Quadranten A, B, C und D. Hierbei wird vorausgesetzt, dass der Abgriff 45 bei jedem Quadranten vorhanden ist, d. h. der Abgriff 45a gilt für den Quadranten A und dem mittleren Statorring 39.

Ein gleicher Abgriff 45a, b dient der Ableitung des Kapazitätswertes aus dem Quadranten B und ein weiterer Abgriff für die Ableitung des Kapazitätswertes aus dem Quadranten C usw.

Die Rotorscheibe 6 unterteilt sich also in zwei Teile, nämlich einen exzentrischen Außenbereich 42 und einen zentrischen Innenbereich mit dem Rotorring 41.

Hieraus ergibt sich ein Konstantkondensator 43, der im Ersatzschaltbild nach Figur 14 dargestellt ist.

In Figur 15 ist ein Kapazitätsverlauf von einem Quadranten bei der Drehung des Rotors im Bezug zum Stator über einen vollen Drehwinkel von 360 Grad dargestellt.

Der Gesamtverlauf setzt sich gemäß den Figuren 16 und 17 zusammen. In Figur 16 sieht man den modulierten Kapazitätsverlauf über 360 Grad, und in Figur 17 ist der um 180 Grad versetzten modulierten Kapazitätsverlauf dargestellt, wobei beispielsweise die Quadraten B und D gegeneinander ausgelesen werden, um so den Verlauf der Figuren 16 und 17 zu erhalten. Als Summe aus diesen beiden Werten ergibt sich die Summenkurve nach Figur 18, wobei hiermit die Kapazitätswerte verdoppelt werden. Damit ergibt sich eine hochgenaue Auslesung, weil verdoppelte Kapazitätswerte günstiger als einfache Kapazitätswerte ausgelesen werden können. Die Auswerteschaltung ist damit einfacher und genauer.

Die mathematische Summierung der beiden Messwerte aus den Figuren 16 und 17 führt zu der Summenkurve nach Figur 18.

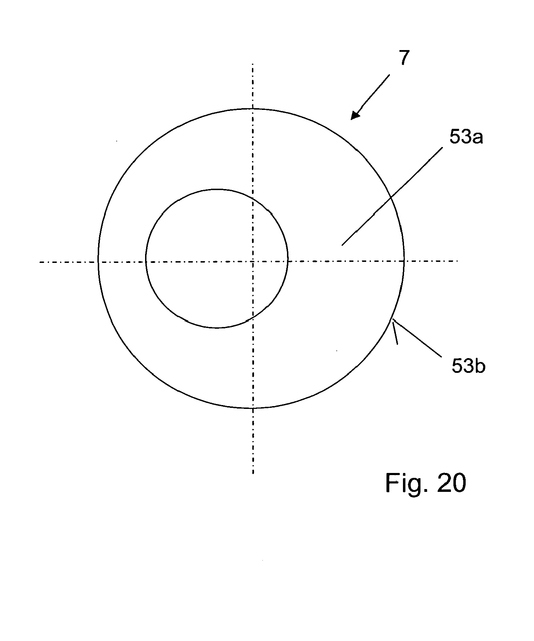

Die Figur 20 zeigt als Ausführungsbeispiel einen Klebering 7, der in die Aussparung 29 des Rotorträgers eingeklebt ist. Es ist erkennbar, dass er einander gegenüberliegende Klebeflächen 53a, 53b aufweist und so als Doppelklebering wirkt.

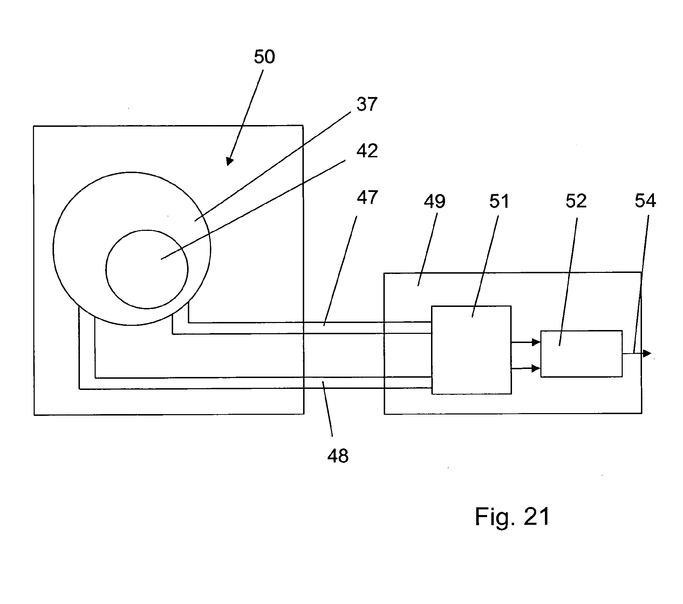

Die Figur 21 zeigt eine Auswerteschaltung eines kapazitiven Sensors 50 nach der Erfindung. Hierbei liegt die Statorfläche 37 der exzentrischen Rotorfläche 42 gegenüber und es sind mehrere Abgreifleitungen 47, 48 vorhanden, wobei über das eine Abgreifleitungspaar 47 der positive und negative Sinus und über das andere Abgreifleitungspaar 48 der positive und negative Kosinuswinkel abgeleitet werden. Beide Kondensatorwerte, die an den einander gegenüberliegenden Elektroden abgegriffen werden, bilden den Eingang für eine Auswerteschaltung 49, die im wesentlichen aus zwei Modulen besteht, nämlich einer Kapazitätsmessschaltung 51 und einer zugeordneten Auswerteschaltung 52, mit der digitale Werte auf der Ausgangsleitung 54 ausgegeben werden.

### Zeichnungslegende

- 1: Gehäuseflansch
- 2: Kugellager
- 3: Welle
- 4: Spannring
- 5: Rotorträger
- 6: Rotorscheibe (exzentrisch)
- 7: Klebering
- 8: Leiterplatte (Stator)
- 9: Klappe
- 10: Befestigungsschraube
- 11: Befestigungsbohrung
- 12: Durchkontaktierung
- 13: Leitschicht
- 14: Ring-Flansch (Kappe 9)
- 15: Innenbohrung (8)
- 16: Abschrägung
- 17: Passfläche
- 18: Elektro-Anschluss
- 19: Luftspalt
- 20: Ausnehmung
- 21: Rändelpassfläche
- 22: Verzahnung
- 23: Montageöffnung
- 24: Gewindebohrung
- 25: Passfläche
- 26: vertikaler Flansch (9)
- 27: horizontaler Flansch (9)
- 28: Elektronikschaltung
- 29: Aussparung (18)
- 30: Vertiefung (für 6)
- 31: Mittenbohrung (von 5)
- 32: Aussparung für Gewichtsausgleich
- 33: Einführschräge
- 34: Klebefläche
- 35: Anschlagfläche
- 36: Passfläche
- 37: Statorfläche
- 38: a, b, c, d Quadrant (Stator)
- 39: Statorring
- 40: Isoliersteg
- 41: Rotorring (von 6)
- 42: Exzentrischer Außenbereich (von 6)
- 43: Konstant-Kondensator (41)
- 44: variabler Kondensator
- 45: Abgriff a, b
- 46: Isolierring
- 47: Abgreifleitung
- 48: Abgreifleitung
- 49: Meßschaltung
- 50: kapazitiver Sensor
- 51: Kapazitäts-Meßschaltung
- 52: Auswerteschaltung
- 53: Klebefläche a - oben, b - unten
- 54: Ausgangsleitung

## Patentansprüche

1. Kapazitiver Drehsensor zum Erfassen der Position eines sich relativ zu einem stationären Objekt bewegenden Objekts, bestehend aus einer drehbar in einem Gehäuseflansch (1) gelagerten Welle (3), die drehfest mit einem Rotor (5, 6) verbunden ist, dem durch einen Luftspalt (19) getrennt gegenüberliegend ein Stator (8) zugeordnet ist, wobei mindestens Rotor (5, 6), der Stator (8) und eine Auswerteschaltung (28) von einer elektrisch leitfähigen Kappe umgeben sind, **dadurch gekennzeichnet, dass** an der Unterseite einer Leiterplatte (8) eine Statorfläche (37) angeordnet ist und dass der Statorfläche (37) gegenüberliegend und durch den Luftspalt (19) getrennt eine nicht-rotationssymmetrische Rotorscheibe (6) zugeordnet ist, die ihrerseits auf einem Rotorträger (5) befestigt ist, welcher Rotorträger (5) drehfest am Außenumfang der Welle (3) hochgenau befestigt ist.

2. Drehsensor nach Anspruch 1, **dadurch gekennzeichnet, dass** die Leiterplatte (8) an ihrer Unterseite die elektrisch leitfähige Statorfläche (37) trägt, die aus einer Kupferleiterbahn besteht ist, die mit einem Isolierlack beschichtet ist.

3. Drehsensor nach Anspruch 1 oder 2, **dadurch gekennzeichnet, dass** die Leiterplatte (8) die elektronische Auswerteschaltung und die Schaltung zur Fehlerkorrektur trägt.

4. Drehsensor nach einem der Ansprüche 1 bis 3, **dadurch gekennzeichnet, dass** zur Erreichung einer hochgenauen, gegen Unwucht geschützten Anordnung vorgesehen ist, dass die exzentrische Rotorscheibe (5, 6) aus einer Kupferfläche besteht, die auf einem isolierenden Rotorträger (5) angeordnet ist.

5. Drehsensor nach einem der Ansprüche 1 bis 4, **dadurch gekennzeichnet, dass** der Rotorträger (5) als einfaches, kostengünstiges Kunststoffteil ausgebildet ist, das hochgenau und formschlüssig am Außenumfang der Welle (3) aufgepasst ist.

6. Drehsensor nach einem der Ansprüche 1 bis 5, **dadurch gekennzeichnet, dass** auf dem Rotorträger (5) eine einseitig offene Ausnehmung (30) angeordnet ist, in welche die exzentrische Rotorscheibe (6) eingesetzt ist.

7. Drehsensor nach einem der Ansprüche 1 bis 6, **dadurch gekennzeichnet, dass** die Rotorscheibe (6) in die Ausnehmung (30) eingeklebt ist.

8. Drehsensor nach einem der Ansprüche 1 bis 7, **dadurch gekennzeichnet, dass** die Rotorscheibe (6) in der Ausnehmung mit einem doppelt klebenden Klebering (7) festgelegt ist.

9. Drehsensor nach einem der Ansprüche 1 bis 8, **dadurch gekennzeichnet, dass** der Rotorträger (5) spannungsfrei auf dem Außenumfang der Welle (3) formschlüssig und drehfest festgelegt ist.

10. Drehsensor nach Anspruch 9, **dadurch gekennzeichnet, dass** am Außenumfang der Welle (3) eine Verzahnung (22) angeordnet ist und der Rotorträger (5) an seinem Innenumfang eine zugeordnete Verzahnung aufweist, so dass eine drehfeste, formschlüssige Verbindung zwischen Rotorträger und dem Außenumfang der Welle vorhanden ist.

11. Drehsensor nach Anspruch 9, **dadurch gekennzeichnet, dass** der Rotorträger (5) aus einem Kunststoffmaterial besteht und unmittelbar auf den Außenumfang der metallischen Welle (3) angespritzt ist.

12. Drehsensor nach einem der Ansprüche 1 bis 11, **dadurch gekennzeichnet, dass**, die Leiterplatte (8) über einen Flansch in der den gesamten Drehsensor (50) abdeckenden Kappe (9) angeordnet ist und die Kappe (9) sich ihrerseits an dem Gehäuseflansch (1) abstützt, der über eine Drehlageranordnung (2, 4) auf der Welle (3) zentriert ist.

13. Drehsensor nach Anspruch 12, **dadurch gekennzeichnet, dass** eine hochgenaue Maßübertragung **dadurch** erreicht ist, dass am Außenumfang der Welle (3) zwei gegeneinander vorgespannte Kugellager (2) angeordnet sind, die den Gehäuseflansch (1) tragen.

14. Drehsensor nach einem der Ansprüche 1 bis 13, **dadurch gekennzeichnet, dass** der Außenumfang des Gehäuseflansches (1) als Zentrierfläche für den Innenumfang der darauf gesteckten Kappe (9) dient und dass die Kappe (9) dieses zentrische Maß auf einen axial innen liegenden Ring-Flansch (14) überträgt, an dessen unteren Stirnseite eine Abschrägung (16) vorhanden ist, an der hochgenau mit Hilfe einer Passfläche (17) der innere Umfang der Leiterplatte (8) anliegt, um so hochgenau im Gehäuse zentriert zu werden.

15. Drehsensor nach einem der Ansprüche 1 bis 14, **dadurch gekennzeichnet, dass** die Welle (3) über die Kugellager (2) im Gehäuseflansch (1) drehbar gelagert ist und dass die Welle (3) sich mit einem unteren, verlängerten Teil aus dem Gehäuse des kapazitiven Drehsensors heraus erstreckt und mit Hilfe eines Spannrings (4) gegen Herausfallen gesichert ist.

16. Drehsensor nach einem der Ansprüche 1 bis 15, **dadurch gekennzeichnet, dass** der obere, verkürzte Teil der Welle (3) im Gehäuseflansch (1) angeordnet und von der Kappe (9) überdeckt ist.

17. Drehsensor nach einem der Ansprüche 1 bis 16, **dadurch gekennzeichnet, dass** die Kappe (9) aus einem äußeren vertikalen Flansch (26) besteht, der sich als Ringflansch gleichmäßig am Außenumfang des Gehäuseflansches (1) im Bereich einer Passfläche (25) anlegt, und dass dieses Passmaß über den vertikalen Flansch (26) auf den horizontalen Flansch (27) der Kappe (9) übertragen wird und von dort auf einen inneren Ringflansch (14) der Kappe (9), welcher die Leiterplatte (8) zentriert.

18. Drehsensor nach einem der Ansprüche 1 bis 17, **dadurch gekennzeichnet, dass** eine hochgenaue Zentrierung zwischen dem Ringflansch (14) der Kappe (9) und dem Innenumfang der Leiterplatte (8) vorgesehen ist und dass die Leiterplatte (8) am Innenumfang eine Innenbohrung (15) aufweist, die sich an einer vertikalen Passfläche (17) am Innenumfang des Ringflansches (14) der Kappe (9) anlegt.

19. Drehsensor nach Anspruch 18, **dadurch gekennzeichnet, dass** die Leiterplatte (8) am radialen Innenumfang eine Innenbohrung (15) aufweist, die sich an einer zugeordneten vertikalen Passfläche (17) am Innenumfang des Ringflansches (14) der Kappe (9) anlegt

20. Drehsensor nach einem der Ansprüche 1 bis 19, **dadurch gekennzeichnet, dass** der Rotorträger (5) ist in einer Ausnehmung (20) des Gehäuseflansches (1) drehbar gelagert und mit Hilfe einer Rändelpassfläche (21) auf dem Außenumfang der Welle (3) zentriert ist.

21. Drehsensor nach einem der Ansprüche 1 bis 20, **dadurch gekennzeichnet, dass** im Bereich der Mittenbohrung (31) des Rotorträgers (5) eine obere Klebefläche (34) als abgeschrägte Fläche ausgebildet ist, in deren Bereich eine Kleberaupe angeordnet ist, um den Rotorträger (5) vor dem Abfallen von der Welle (3) nach oben in axialer Richtung zu sichern.

22. Drehsensor nach einem der Ansprüche 1 bis 21, **dadurch gekennzeichnet, dass** exzentrisch im Außenbereich des Rotorträgers (5) eine Aussparung (32) als Gewichtsausgleich angeordnet ist.

23. Drehsensor nach einem der Ansprüche 1 bis 22, **dadurch gekennzeichnet, dass** die Statorfläche (37) elektrisch leitfähige, jedoch durch radial verlaufende Isolierstege voneinander getrennte Quadranten (38a, 38b, 38c, 38d) aufweist, die als leitfähige Beläge ausgebildet und gegenseitig voneinander isoliert sind

24. Drehsensor nach Anspruch 23, **dadurch gekennzeichnet, dass** die Quadranten (38a-d) am Innenumfang durch einen umlaufenden, elektrisch isolierenden Isolierring 46 voneinander getrennt sind und dass am Innenumfang des Isolierrings (46) ein elektrisch leitfähiger, zentrischer Statorring 39 angeordnet ist.

25. Drehsensor nach einem der Ansprüche 1 bis 24, **dadurch gekennzeichnet, dass** die exzentrische Rotorscheibe (6) einen inneren zentrischen Rotorring (41) aufweist, der als leitfähiger Belag elektrisch leitfähig mit den übrigen exzentrischen Bereichen der Rotorscheibe (6) verbunden ist.

26. Drehsensor nach einem der Ansprüche 1 bis 25, **dadurch gekennzeichnet, dass** die Rotorscheibe (6) in einen exzentrischen Außenbereich (42) und einen zentrischen Innenbereich mit dem Rotorring (41) unterteilt ist.
